# FASCICULE DE BREVET EUROPEEN

(11) **EP 2 123 137 B1**
(45) Date de publication et mention de la délivrance du brevet: **05.01.2011**
(21) Numéro de dépôt: 08775569.0
(22) Date de dépôt: 18.02.2008
(51) Int. Cl.: H05K 1/02

(54) **CARTE ELECTRONIQUE ET AERONEF LA COMPORTANT**
ELEKTRONIKKARTE UND FLUGZEUG DAMIT
ELECTRONIC CARD AND AIRCRAFT INCLUDING SAME

(30) Priorité: 22.02.2007 FR 0753433
(43) Date de publication de la demande: 25.11.2009
(73) Titulaire: Airbus Operations, 31060 Toulouse (FR)
(72) Inventeur: ORTET, Stéphane, F-31700 Mondonville (FR); REBEYROTTE, Vincent, F-31770 Colomiers (FR); ROUSSET, David, F-31300 Toulouse (FR)
(74) Mandataire: Santarelli
(86) Numéro de dépôt international: PCT/FR2008/000211
(87) Numéro de publication internationale: WO 2008/129155

(56) Documents cités:
- FR-A1- 2 853 489
- US-A- 3 244 795

## Description

La présente invention concerne une carte électronique destinée par exemple à être intégrée dans des équipements embarqués pour aéronefs le document FR 2853489 décrit une carte électronique selon le préambule de la revendication 1.

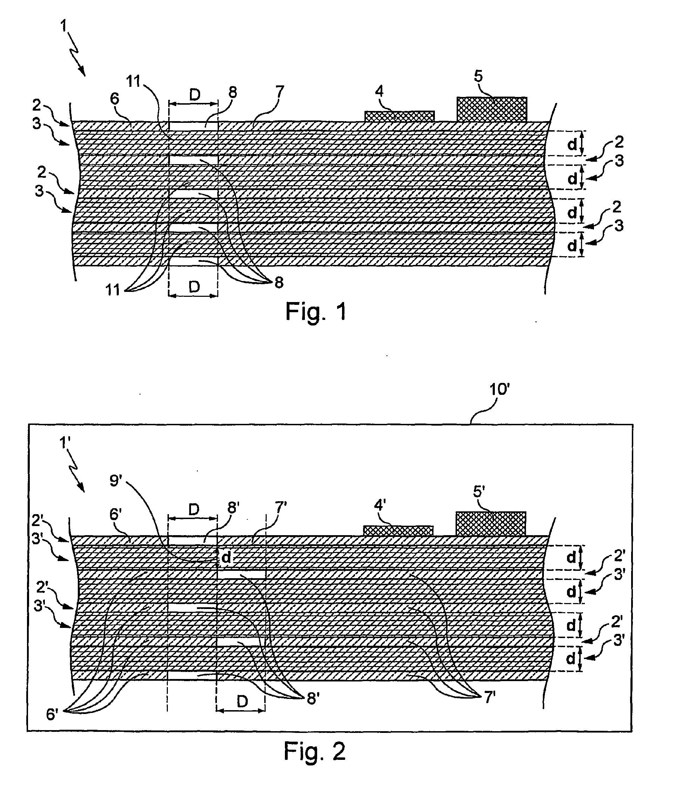

On connaît déjà des cartes électroniques, comme représentées schématiquement sur la figure 1, comportant au moins deux couches conductrices superposées 2 séparées entre elles par des couches isolantes sur le plan électrique 3. -

Chaque couche conductrice 2 présente au moins une portion conductrice périphérique 6 et une portion conductrice centrale utile 7 adaptée à être reliée électriquement à des éléments électroniques 4, 5 et séparée de la portion 6 par une portion isolante 8 dont les dimensions et le matériau sont choisis pour assurer une isolation électrique suffisante entre les portions 6 et 7.

Le matériau et les dimensions des couches 3 sont également choisis pour assurer une isolation électrique suffisante entre les couches 2.

Sur ces cartes, les portions isolantes 8 sont superposées les unes aux autres avec, intercalée entre deux portions 8 voisines, une portion 11 d'une couche isolante intermédiaire 3.

L'invention vise à fournir une carte électronique du même type aussi fiable mais présentant des performances améliorées sur le plan de la dissipation thermique.

Elle propose à cet effet, une carte électronique comportant au moins deux couches conductrices superposées, avec entre lesdites deux couches conductrices une couche isolante sur le plan électrique, lesdites deux couches conductrices présentant chacune une portion conductrice utile et une portion conductrice située à la périphérie de ladite portion conductrice utile avec entre lesdites portions conductrices une portion isolante sur le plan électrique, **caractérisée en ce que** ladite portion isolante d'une première desdites deux couches est décalée par rapport à la portion isolante de la deuxième desdites deux couches de sorte au'une partie de la portion conductrice utile de la première desdites deux couches est située au droit d'une partie de la portion isolante de la deuxième desdites deux couches et qu'une partie de la portion périphérique de la deuxième desdites deux couches est située au droit d'une partie de la portion isolante de la première desdites deux couches.

Le décalage des portions isolantes d'une couche à l'autre permet ainsi de « rapprocher » la portion conductrice utile d'une des deux couches (à laquelle sont reliés électriquement des composants électroniques qui sont des sources de chaleur lorsqu'ils sont en fonctionnement) de la portion périphérique de l'autre couche. Les portions isolantes (mauvaises conductrices de chaleur) n'étant plus superposées, l'effet de barrière thermique lié à l'empilement sur une même zone de ces portions isolantes comme dans les cartes de l'art antérieur susmentionnées est ainsi considérablement réduit puisque le décalage de ces portions d'une couche à l'autre permet de diminuer la distance séparant deux portions conductrices sur le plan électrique (également bonnes conductrices de chaleur) situées sur deux couches différentes et à l'opposées l'une de l'autre par rapport aux portions isolantes, de sorte que le transfert de chaleur par conduction peut ainsi s'opérer entre ces portions d'une couche à l'autre.

La chaleur à dissiper provenant des composants électroniques et véhiculée par les portions conductrices utiles peut ainsi être plus efficacement évacuée en direction des couches voisines.

La carte selon l'invention permet ainsi de répondre à deux besoins pourtant antagonistes à savoir obtenir une bonne isolation galvanique tout en conservant un pouvoir de dissipation thermique suffisant.

Cet agencement garantit ainsi une dissipation thermique améliorée évitant les risques de surchauffe, ce qui contribue à augmenter la fiabilité de fonctionnement de l'équipement électronique en particulier dans le cas où celui-ci est disposé dans une enceinte étanche, la dissipation thermique se faisant dans ce cas essentiellement par conduction.

Selon les caractéristiques préférées, pour des raisons de simplicité et de commodité tant à la fabrication qu'à l'utilisation lesdites portions isolantes desdites deux couches ont les mêmes dimensions.

Selon d'autres caractéristiques préférées pour les mêmes raisons que celles exposées ci-dessus ledit décalage est sensiblement égal à la distance séparant lesdites portions conductrices d'une même couche.

De cette façon la carte selon l'invention est ainsi optimisée pour faciliter la dissipation thermique en réduisant la distance entre deux portions conductrices de deux couches voisines à l'opposé l'une de l'autre par rapport aux portions isolantes tout en assurant une isolation galvanique suffisante, ces couches étant plus proches l'une de l'autre mais sans se superposer pour autant afin d'éviter tout risque de couplage capacitif entre couches conductrices risquant de dégrader l'isolation galvanique.

Selon encore d'autres caractéristiques préférées :
- ladite carte comporte au moins trois couches conductrices dont les portions isolantes sont décalées alternativement dans un sens puis dans le sens opposé d'une couche à l'autre ;
- lesdites portions isolantes sont en époxy ;
- lesdites couches isolantes sont en matériau isolant à base de fibres de verre ;
- la largeur d'une portion isolante est supérieure à l'épaisseur d'une couche isolante ;
- le rapport entre la largeur d'une portion isolante et l'épaisseur d'une couche isolante est supérieur à cinq ; et/ou
- pour chaque dite couche, ladite portion utile est adaptée à être connectée électriquement à des composants électroniques.

L'invention vise également sous un deuxième aspect, un aéronef comportant une enceinte dans laquelle est disposée au moins une carte telle qu'exposée ci-dessus.

Selon d'autres caractéristiques préférées pour les mêmes raisons que celles exposées ci-dessus :
- ladite enceinte est une enceinte étanche ; et/ou
- au moins une portion périphérique de chaque dite carte électronique disposée dans l'enceinte est reliée électriquement au châssis de l'aéronef.

L'exposé de l'invention sera maintenant poursuivi par la description détaillée d'un exemple de réalisation, donné ci-après à titre illustratif mais non limitatif, en référence aux dessins annexés, sur lesquels :
- la figure 1 est une représentation schématique en coupe d'une carte électronique de l'art antérieur ; et
- la figure 2 est une représentation schématique en coupe d'une carte électronique conforme à l'invention.

La carte électronique 1' conforme à l'invention et illustrée en figure 2 comporte un support de carte (non représenté) sur lequel sont déposées plusieurs couches conductrices 2' (en cuivre) entre lesquelles sont intercalées des couches 3' d'épaisseur d réalisées en matériau isolant à base de fibres de verre tissées (par exemple en matériau connu sous la dénomination « FR4 »).

Dans l'exemple illustré, cette carte 1' est disposée avec d'autres cartes du même type dans une enceinte étanche 10' que comporte l'armoire électronique d'un aéronef.

Chaque couche conductrice 2' présente une portion conductrice périphérique 6' et une portion conductrice centrale utile 7', la portion 7' étant séparée de la portion 6' par une portion isolante en époxy 8'.

Sur la portion 7' de la couche conductrice supérieure sont fixés les composants électroniques 4' et 5', ceux-ci étant reliés électriquement à cette portion ou aux portions 7' inférieures par l'intermédiaire de vias (non représentés).

La portion périphérique 6' est reliée électriquement au châssis de l'équipement ou de l'aéronef, la portion 7' quant à elle est isolée du châssis grâce à la portion 8' de sorte que cette carte électronique forme un équipement flottant, la partie supportant les éléments actifs 4' et 5' étant isolée du châssis.

Les portions isolantes 8' présentent une largeur D déterminée pour garantir un isolement galvanique suffisant entre les portions 6' et 7' d'une même couche 2', en particulier dans le cas où ce dispositif est amené à atteindre des altitudes élevées comme cela est le cas des équipements embarqués dans le domaine aéronautique.

Dans l'exemple illustré, et afin d'assurer une isolation de 1600V entre les portions 6' et 7' d'une même couche 2', la largeur D est égale à 800 µm.

La distance d quant à elle est choisie pour assurer un isolement suffisant entre deux couches adjacentes 2' tout en conservant un encombrement minimum. Cette distance est plus faible que la distance D car le matériau FR4 ici utilisé présente un pouvoir isolant supérieur à celui de l'époxy. Dans l'exemple illustré la distance d est égale à 80 µm, le ratio D/d étant alors égal à 10.

La tension d'isolement plans/châssis ici obtenu est égale à 500V.

Cet agencement permet ainsi d'obtenir un bon isolement galvanique et également de bonnes performances du point de vue de la compatibilité électromagnétique.

Dans la carte électronique selon l'invention les portions isolantes 8' sont décalées les unes par rapport aux autres d'une distance égale à leur largeur D dans un sens qui est alterné au passage d'une couche conductrice à l'autre de sorte que cette carte présente une structure en peigne comme illustrée en figure 2.

Une partie de la portion conductrice utile 7' de la couche supérieure 2' est ainsi située au droit de la portion isolante 8' de la couche 2' qui lui est directement inférieure, une partie de la portion périphérique 6' de cette couche étant elle située au droit de la portion isolante 8' de la couche supérieure.

Ce décalage de couche en couche fait ainsi que chaque portion isolante 8' est située au droit d'une partie d'une portion conductrice 6' ou 7' des couches 2' qui lui sont directement voisines, ces parties de portions conductrices étant elles-mêmes situées au droit de la portion isolante 8' de la couche voisine 2' suivante opposée et ainsi de suite.

La portion 6' d'une couche 2' se retrouve ainsi plus proche des portions 7' des couches 2' voisines, la distance minimale séparant cette portion 6' des portions 7' des couches voisines étant égale à l'épaisseur d de la couche 3' comme représentée par la double flèche repérée par la référence 9' sur la figure 2.

Le décalage des portions 8' entre couches est ainsi égal à la distance séparant les portions 6' et 7' d'une même couche de sorte que deux portions 6' et 7' sont au plus près l'une de l'autre mais sans se superposer afin de favoriser la dissipation thermique tout en évitant les phénomènes de couplage capacitif entre portions 6' et 7' de couches différentes (nuisibles à l'isolation galvanique).

La distance d étant très inférieure à la distance D, la conduction thermique est largement améliorée. En effet, d'une couche à l'autre et pour passer d'une portion 7' d'une couche à la portion 6' des couches voisines, la chaleur sera facilement évacuée, la distance minimale d'isolant (mauvais conducteur de chaleur) à parcourir étant dans ce cas réduite à d (référence 9') contre une distance égale à D dans l'art antérieur (c'est-à-dire la distance séparant deux portions 6, 7 d'une même couche).

Ainsi dans la carte de l'art antérieur l'évacuation de chaleur s'effectue principalement dans le plan des couches (horizontalement sur la figure 1) en raison de la forte isolation thermique dû à l'empilement des portions 8 tandis que dans la carte selon l'invention le décalage des portions 8' permet une évacuation de chaleur transversalement au plan des couches (c'est-à-dire verticalement sur la figure 2).

L'évacuation de chaleur peut ainsi s'effectuer beaucoup plus facilement d'une couche à l'autre afin de maintenir cette carte dans des conditions de température acceptables pour garantir un fonctionnement nominal des composants électroniques.

De telles cartes sont en particulier utilisées sur les calculateurs de secours d'aéronefs dans lesquels il a ainsi pu être observé que pour une isolation galvanique égale, la résistance thermique du pourtour de la carte était deux fois plus faible dans le cas d'une architecture en peigne (figure 2) que dans le cas d'une architecture isolée de manière traditionnelle (figure 1).

On remarquera au surplus que cet agencement en peigne n'engendre pas de coût de fabrication supplémentaire sur la plaque de circuit imprimé. Il reste ainsi particulièrement économique et pratique à mettre en oeuvre.

Dans une variante non illustrée, le décalage entre deux portions isolantes 8' de deux couches voisines est inférieur à la largeur D de sorte que seule une partie des portions isolantes est située au droit d'une partie des portions conductrices correspondantes.

Dans encore une autre variante non illustrée le décalage des portions isolantes ne se fait pas selon un sens alterné d'une couche à l'autre mais toujours selon un même sens et/ou le décalage entre deux portions isolantes de deux couches voisines est supérieur à la largeur D.

Dans encore une autre variante non illustrée les portions isolantes présentent des dimensions variables d'une couche à l'autre.

De nombreuses autres variantes sont possibles en fonction des circonstances, et l'on rappelle à cet égard que l'invention ne se limite pas aux exemples décrits et représentés.

## Revendications

1. Carte électronique comportant au moins deux couches conductrices superposées (2'), avec entre lesdites deux couches conductrices (2') une couche isolante sur le plan électrique (3'), lesdites deux couches conductrices (2') présentant chacune une portion conductrice utile (7') et une portion conductrice (6') située à la périphérie de ladite portion conductrice utile (7') avec entre lesdites portions conductrices (6', 7') une portion isolante sur le plan électrique (8'), **caractérisée en ce que** ladite portion isolante (8') d'une première desdites deux couches (2') est décalée par rapport à la portion isolante (8') de la deuxième desdites deux couches (2') de sorte qu'une partie de la portion conductrice utile (7') de la première desdites deux couches (2') est située au droit d'une partie de la portion isolante (8') de la deuxième desdites deux couches (2') et qu'une partie de la portion périphérique (6') de la deuxième desdites deux couches (2') est située au droit d'une partie de la portion isolante (8') de la première desdites deux couches (2').

2. Carte selon la revendication 1, **caractérisée en ce que** lesdites portions isolantes (8') desdites deux couches ont les mêmes dimensions.

3. Carte selon l'une quelconque des revendications 1 ou 2, **caractérisée en ce que** ledit décalage est sensiblement égal à la distance (D) séparant lesdites portions conductrices (6', 7') d'une même couche (2').

4. Carte selon l'une quelconque des revendications 1 à 3, **caractérisée en ce qu'**elle comporte au moins trois couches conductrices (2') dont les portions isolantes (8') sont décalées alternativement dans un sens puis dans le sens opposé d'une couche à l'autre.

5. Carte selon l'une quelconque des revendications 1 à 4, **caractérisée en ce que** lesdites portions isolantes (8') sont en époxy.

6. Carte selon l'une quelconque des revendications 1 à 5, **caractérisée en ce que** lesdites couches isolantes (3') sont en matériau isolant à base de fibres de verre.

7. Carte selon l'une quelconque des revendications 1 à 6, **caractérisée en ce que** la largeur (D) d'une portion isolante (8') est supérieure à l'épaisseur (d) d'une couche isolante (3').

8. Carte selon la revendication 7, **caractérisé en ce que** le rapport entre la largeur (D) d'une portion isolante (8') et l'épaisseur (d) d'une couche isolante (3') est supérieur à cinq.

9. Carte selon l'une quelconque des revendications 1 à 8, **caractérisée en ce que** pour chaque dite couche (2'), ladite portion utile (7') est adaptée à être connectée électriquement à des composants électroniques (4',5').

10. Aéronef comportant une enceinte (10') dans laquelle est disposée au moins une carte selon l'une quelconque des revendications 1 à 9.

11. Aéronef selon la revendication 10, **caractérisé en ce que** ladite enceinte (10') est une enceinte étanche.

12. Aéronef selon l'une quelconque des revendications 10 ou 11, **caractérisé en ce qu'**au moins une portion périphérique (6') de chaque dite carte électronique disposée dans l'enceinte (10') est reliée électriquement au châssis de l'aéronef.

## Claims

1. An electronic card comprising at least two superposed conductive layers (2'), having an electrically insulating layer (3') between the said two conductive layers (2'), the said two conductive layers (2') each having a useful conductive portion (7') and a conductive portion (6') situated at the periphery of the said useful conductive portion (7'), and an electrically insulating portion (8') between the said conductive portions (6', 7'), **characterized in that** the said insulating portion (8') of a first of the said two layers (2') is offset relative to the insulating portion (8') of the second of the said two layers (2'), such that part of the useful conductive portion (7') of the first of the said two layers (2') is situated in vertical alignment with part of the insulating portion (8') of the second of the said two layers (2'), and that part of the peripheral portion (6') of the second of the said two layers (2') is situated in vertical alignment with part of the insulating portion (8') of the first of the said two layers (2').

2. A card according to claim 1, **characterized in that** the said insulating portions (8') of the said two layers have the same dimensions.

3. A card according to any one of claims 1 or 2, **characterized in that** the said offset is substantially equal to the distance (D) separating the said conductive portions (6', 7') of the same layer (2').

4. A card according to any one of claims 1 to 3, **characterized in that** it is provided with at least three conductive layers (2'), whose insulating portions (8') are offset alternately in one direction then in the opposite direction from one layer to the other.

5. A card according to any one of claims 1 to 4, **characterized in that** the said insulating portions (8') are made of epoxy.

6. A card according to any one of claims 1 to 5, **characterized in that** the said insulating layers (3') are made of insulating material based on glass fibers.

7. A card according to any one of claims 1 to 6, **characterized in that** the width (D) of an insulating portion (8') is greater than the thickness (d) of an insulating layer (3').

8. A card according to claim 7, **characterized in that** the ratio between the width (D) of an insulating portion (8') and the thickness (d) of an insulating layer (3') is greater than five.

9. A card according to any one of claims 1 to 8, **characterized in that**, for each said layer (2'), the said useful portion (7') is adapted to be connected electrically to electronic components (4', 5').

10. An aircraft equipped with a compartment (10') in which there is disposed at least one card according to any one of claims 1 to 9.

11. An aircraft according to claim 10, **characterized in that** the said compartment is a fluid-tight compartment.

12. An aircraft according to any one of claims 10 or 11, **characterized in that** at least one peripheral portion (6') of each said electronic card disposed in the compartment (10') is connected electrically to the frame of the aircraft.

## Patentansprüche

1. Elektronikkarte, umfassend mindestens zwei übereinander angeordnete leitende Schichten (2') und zwischen diesen beiden leitenden Schichten (2') eine elektrisch isolierende Schicht (3'), wobei die beiden leitenden Schichten (2') jeweils einen leitenden Nutzteil (7') und einen am Umfang des leitenden Nutzteils (7') gelegenen leitenden Teil (6') aufweisen, wobei zwischen diesen leitenden Teilen (6', 7') ein elektrisch isolierender Teil (8') vorgesehen ist, **dadurch gekennzeichnet, dass** der isolierende Teil (8') einer ersten der beiden Schichten (2') bezüglich des isolierenden Teils (8') der zweiten der beiden Schichten (2') so versetzt ist, dass ein Teil des leitenden Nutzteils (7') der ersten der beiden Schichten (2') auf Höhe eines Teils des isolierenden Teils (8') der zweiten der beiden Schichten (2') gelegen ist und ein Teil des Umfangsteils (6') der zweiten der beiden Schichten (2') auf Höhe eines Teils des isolierenden Teils (8') der ersten der beiden Schichten (2') gelegen ist.

2. Karte nach Anspruch 1, **dadurch gekennzeichnet, dass** die isolierenden Teile (8') der beiden Schichten diesselben Abmessungen besitzen.

3. Karte nach einem der Ansprüche 1 oder 2, **dadurch gekennzeichnet, dass** die Versetzung im Wesentlichen gleich dem Abstand (D) zwischen den leitenden Teilen (6', 7') ein und derselben Schicht (2') ist.

4. Karte nach einem der Ansprüche 1 bis 3, **dadurch gekennzeichnet, dass** sie mindestens drei leitende Schichten (2') umfasst, deren isolierende Teile (8') von einer Schicht zur anderen abwechselnd in einem Sinn und dann im entgegengesetzten Sinn versetzt sind.

5. Karte nach einem der Ansprüche 1 bis 4, **dadurch gekennzeichnet, dass** die isolierenden Teile (8') aus Epoxid bestehen.

6. Karte nach einem der Ansprüche 1 bis 5, **dadurch gekennzeichnet, dass** die isolierenden Schichten (3') aus einem isolierenden Werkstoff auf Glasfaserbasis bestehen.

7. Karte nach einem der Ansprüche 1 bis 6, **dadurch gekennzeichnet, dass** die Breite (D) eines isolierenden Teils (8') größer als die Dicke (d) einer isolierenden Schicht (3') ist.

8. Karte nach Anspruch 7, **dadurch gekennzeichnet, dass** das Verhältnis zwischen der Breite (D) eines isolierenden Teils (8') und der Dikke (d) einer isolierenden Schicht (3') größer als fünf ist.

9. Karte nach einem der Ansprüche 1 bis 8, **dadurch gekennzeichnet, dass** der Nutzteil (7') bei jeder Schicht (2') dafür ausgelegt ist, an elektronische Bauelemente (4', 5') elektrisch angeschlossen zu werden.

10. Luftfahrzeug, umfassend eine Kammer (10'), in der mindestens eine Karte nach einem der Ansprüche 1 bis 9 angeordnet ist.

11. Luftfahrzeug nach Anspruch 10, **dadurch gekennzeichnet, dass** die Kammer (10') eine dichte Kammer ist.

12. Luftfahrzeug nach einem der Ansprüche 10 oder 11, **dadurch gekennzeichnet, dass** mindestens ein Umfangsteil (6') jeder in der Kammer (10') angeordneten Elektronikkarte mit dem Rahmen des Luftfahrzeugs elektrisch verbunden ist.
